# EUROPÄISCHE PATENTSCHRIFT

(11) **EP 2 885 564 B1**
(45) Veröffentlichungstag und Bekanntmachung des Hinweises auf die Patenterteilung: **22.03.2017**
(21) Anmeldenummer: 12748393.1
(22) Anmeldetag: 16.08.2012
(51) Int. Cl.: F16K 31/00

(54) **FLUIDVENTIL**
FLUID VALVE
VALVE FLUIDIQUE

(43) Veröffentlichungstag der Anmeldung: 24.06.2015
(73) Patentinhaber: Festo AG & Co. KG, 73734 Esslingen (DE)
(72) Erfinder: MAICHL, Martin, 73084 Salach (DE); DICKHOFF, Andreas, 73230 Kirchheim (DE)
(74) Vertreter: Patentanwälte Magenbauer & Kollegen Partnerschaft mbB
(86) Internationale Anmeldenummer: PCT/EP2012/003481
(87) Internationale Veröffentlichungsnummer: WO 2014/026699

(56) Entgegenhaltungen:
- DE-B3- 10 311 239
- DE-B3-102007 028 673
- US-A- 5 340 081
- US-A1- 2011 168 929

## Beschreibung

Die Erfindung betrifft ein Fluidventil zur Beeinflussung einer Fluidströmung, mit einem Ventilgehäuse, in dem ein Aktor aufgenommen ist, der zwischen einer ersten und einer zweiten Funktionsstellung bewegbar ist, mit einem Fluidkanal, der das Ventilgehäuse bereichsweise durchsetzt und im Ventilgehäuse an einem Ventilsitz ausmündet, mit einem Dichtmittel, das mit dem Aktor bewegungsgekoppelt ist und das in Abhängigkeit von der Funktionsstellung des Aktors für eine zeitweilige Abdichtung des Ventilsitzes ausgebildet ist, wobei dem Aktor ein plastisch deformierbares Einstellmittel zugeordnet ist, das zur Einwirkung auf den Aktor ausbildet ist, um eine Einstellung einer Position des Dichtmittels in wenigstens einer der Funktionsstellungen des Aktors zu ermöglichen, wobei das Einstellmittel als positionsveränderliches Widerlager für den Aktor oder für ein zwischen Aktor und Dichtmittel zur Bewegungskopplung angeordnetes Koppelglied ausgebildet ist.

Aus der DE 100 44 212 B4 ist ein Verfahren zur Positionsjustage lageempfindlicher Bauteile, insbesondere von Mikro-Bauteilen der Elektronik, Optoelektronik oder Mechatronik, bekannt, bei dem das Bauteil mit einem mechanisch vorgespannten Aktoren-Element gekoppelt wird und anschließend Material von dem Aktoren-Element in definierten Bereichen abgetragen wird, wobei durch die Materialabtragung und die damit verbundene Änderung des Spannungszustandes am Aktoren-Element eine definierte Formänderung des Aktoren-Elementes und damit eine Lageänderung des Bauteils zu dessen Justage erfolgt.

Die DE 203 15 196 U1 offenbart eine laserjustierbare Halterung für Komponenten, insbesondere für optische Komponenten in Laseranordnungen, mit einem Justierelement, das die optische Komponente oder ein diese tragendes Element in einer Justierebene aufnimmt, wobei das Justierelement durch mehrere Doppelbrückenaktoren gebildet ist, die bei geeigneter Laserbestrahlung eine Veränderung der Lage der Justierebene bewirken, wobei das Justierelement zu einem Rohr geformt ist und eine Stirnseite des Rohres die Justierebene bildet.

Aus der DE 103 11 239 B3 ist ein Verfahren zur Herstellung eines Ventils bekannt, wobei das Ventil mindestens eine von einem Ventilsitz umgebene Ventilöffnung sowie ein längliches, durch Verschwenken wahlweise in einer mit einem Verschlussabschnitt auf dem mindestens einen Ventilsitz aufliegenden Schließstellung oder mindestens einer von dem Ventilsitz abgehobenen Offenstellung positionierbares Ventilglied aufweist, und wobei das Ventilglied nach seiner Fertigmontage in einem zugehörigen Ventilgehäuse lokal kurzzeitig bis zur oberflächlichen Plastifizierung erwärmt wird, um es in seiner Schwenkrichtung mit einer sich auf die Relativlage zwischen dem Verschlussabschnitt und dem diesem zugeordneten Ventilsitz auswirkenden, bleibenden Durchbiegung zu versehen.

Die DE 10 2007 028 673 B3 offenbart ein Ventil, dessen Ventilglied durch eine Blattfeder in eine Ausgangsstellung vorgespannt ist. Die Vorspannung resultiert aus einem Federblatt, das aus seiner vorspannungsfreien Neutrallage relativ zu einem Halteabschnitt in einer Auslenkrichtung in eine vorgespannte Arbeitslage ausgelenkt ist. Das Federblatt weist mindestens eine Knickstelle auf, so dass es trotz starker Auslenkung nur wenig durchgebogen ist und wenig Einbauraum benötigt.

Die US 5,340,081 A beschreibt ein piezoelektrisches Ventil in einem Gaszuführungssystem, das eine Piezokeramik, die mit einer Ventildichtung verbunden und über einem Ventilsitz angeordnet ist und durch einen O- Ring und einem Halter in dieser Position gehalten wird, sowie eine isolierende Kugel umfasst, die normalerweise durch eine Vorspannfeder gegen die Piezokeramik vorgespannt ist. Ein Einlassanschluss ist derart positioniert, dass die Piezokeramik bei einem Einströmen von Gas in das Ventil formschlüssig sitzt. Der Einlassanschluss ist hierfür gegenüberliegend zur Dichtung an der Piezokeramik angeordnet.

Aus dem Stand der Technik sind somit Technologien und Verfahren bekannt, mit denen eine Einstellung einer Lage einer Komponente erreicht werden kann, wobei stets vorgesehen ist, unmittelbaren Einfluss auf die Lagermittel, beispielsweise ein Aktoren-Element oder ein Ventilglied zu nehmen, an denen die Komponente aufgenommen ist oder die die Komponente bilden.

Die Aufgabe der Erfindung besteht darin, ein Fluidventil bereitzustellen, bei dem unabhängig von der Gestaltung des Aktors eine Einstellung wenigstens einer Position des Dichtmittels in wenigstens einer der Funktionsstellungen des Aktors erreicht werden kann.

Diese Aufgabe wird für ein Fluidventil der eingangs genannten Art mit den Merkmalen des Anspruchs 1 oder des Anspruchs 2 gelöst.

Hierbei ist vorgesehen, dass das Einstellmittel zur Veränderung eines Auflageortes des Widerlagers am Aktor oder bei einer alternativen Ausgestaltung am Koppelglied für eine plastische Formänderung mittels eines Energiestrahls, insbesondere eines Laserstrahls, ausgebildet ist..

Hierdurch kann ein automatisierter Einstellprozess für das Fluidventil angewendet werden.

Beispielsweise ist vorgesehen, dass das Fluidventil im fertig zusammengebauten Zustand in eine Prüfvorrichtung aufgenommen wird, in der ein Funktionstest und/oder eine Ermittlung der unterschiedlichen Funktionsstellungen des Aktors und des damit gekoppelten Dichtmittels vorgenommen werden können. Bei Auftreten von Abweichungen von einer vorgebbaren Funktionsweise kann mit Hilfe eines Energiestrahls eine Einstellung des Fluidventils vorgenommen werden.

Diese Einstellung erfolgt dadurch, dass der Energiestrahl, insbesondere durch das Ventilgehäuse hindurch, auf das Einstellmittel gerichtet wird und dort durch lokale Erwärmung, insbesondere durch lokales Aufschmelzen des Einstellmittels, eine Formänderung des Einstellmittels herbeiführt.

Dabei ist das Einstellmittel gemäß einem ersten Erfindungsaspekt derart gestaltet, dass als Resultat der angestrebten Formänderung eine Positionsveränderung eines während einer Bewegung des Aktors zumindest zeitweilig als Widerlager für den Aktor dienenden Bereichs des Einstellmittels erreicht wird.

Sofern der Aktor mit dem Ventilglied über ein Koppelglied kinematisch gekoppelt sein sollte, kann gemäß einem zweiten Erfindungsaspekt vorgesehen sein, dass das Einstellmittel auf das Koppelmittel einwirkt, um die gewünschte Anpassung der Position des Dichtmittels in wenigstens einer der Funktionsstellungen des Aktors zu bewirken.

Das Einstellmittel dient dazu, eine Bewegung und/oder eine Beweglichkeit des Aktors einzustellen, um eine Justage der Position des Dichtmittels in wenigstens einer der Funktionsstellungen des Aktors zu ermöglichen. Durch eine Einflussnahme auf das plastisch deformierbare Einstellmittel kann beispielsweise eine Vorspannung für den Aktor verändert werden. Ergänzend oder alternativ kann mit dem Einstellmittel eine die Bewegung des Aktors beeinflussende Lagerung des Aktors verändert werden, um beispielsweise einen Bewegungsweg des Aktors zu beeinflussen und/oder die Lage des Aktors in wenigstens einer der Funktionsstellungen zu einzustellen. Dabei kann das Einstellmittel derart ausgebildet sein, dass es unabhängig von der Funktionsstellung des Aktors permanent mit dem Aktor in Kontakt steht, also für eine dauerhafte Einwirkung auf den Aktor eingerichtet ist. Alternativ kann vorgesehen sein, dass das Einstellmittel in Abhängigkeit von der Funktionsstellung des Aktors zeitweilig keinen Kontakt mit dem Aktor aufweist. Beispielsweise kann vorgesehen sein, dass der Aktor erst bei einer Bewegung aus der einen Funktionsstellung in die andere Funktionsstellung in Kontakt mit dem Einstellmittel tritt, wodurch die gewünschte Einflussnahme auf das Bewegungsverhalten des Aktors und/oder die Position des Dichtmittels in der angestrebten Funktionsstellung des Aktors beeinflusst werden kann.

Vorteilhafte Weiterbildungen der Erfindung sind Gegenstand der Unteransprüche.

Vorteilhaft ist es, wenn der Aktor als elektrisch ansteuerbares Biegeelement, insbesondere als Piezobiegeelement, für eine Biegebewegung in einer Bewegungsebene ausgebildet ist. Ein derartiges Biegeelement ist in der Lage, sehr schnelle Bewegungen durchzuführen, da es eine geringe Masse aufweist und eine bezogen auf die Masse hohe Stellkraft aufbringen kann. Hierdurch lassen sich sehr schnelle Schaltzeiten für das Fluidventil erreichen, wie sie immer stärker für die verschiedenen Bereiche der fluidischen Automatisierungstechnik verlangt werden. Zudem kann bei Verwendung eines elektrisch ansteuerbaren Biegeelements eine sehr kompakte Bauweise für das Fluidventil erreicht werden. Bei einer Ausgestaltung des Biegeelements als Piezobiegeelement kann vorgesehen sein, dass eine piezoelektrische Beschichtung auf ein federelastisches Substrat aufgebracht wird und derart an diesem Substrat anhaftet, dass bei Anlegen einer elektrischen Spannung an die piezoelektrische Beschichtung eine mechanische Spannung in der piezoelektrischen Beschichtung hervorgerufen wird, die beispielsweise in einer Krümmung des Substrats resultiert. Die Biegebewegung des Biegeelements findet üblicherweise in einer einzigen Bewegungsebene statt, in der ein Krümmungsradius für das Biegeelement in Abhängigkeit von der eingeleiteten elektrischen Spannung auf das Biegeelement veränderlich ist.

Bei einer Weiterbildung der Erfindung ist vorgesehen, dass am Einstellmittel ein Formänderungsbereich ausgebildet ist, der bei Bestrahlung mit einem Energiestrahl für eine Veränderung des Auflageortes des Widerlagers am Aktor ausgebildet ist. Der Formänderungsbereich ist ein punktförmiger oder linienförmiger oder flächiger Oberflächenbereich am Einstellmittel, bei dessen Bestrahlung mit einem Energiestrahl eine signifikante Änderung des Auflageortes des vom Einstellmittel gebildeten Widerlagers am Aktor erreicht werden kann. Beispielsweise weist das Einstellmittel einen Formänderungsbereich auf, bei dessen Bestrahlung mittels des Energiestrahls eine Annäherung des als Widerlager dienenden Bereichs des Einstellmittels an den Aktor bewirkt werden kann.

In weiterer Ausgestaltung der Erfindung ist vorgesehen, dass am Einstellmittel mehrere Formänderungsbereiche ausgebildet sind, die bei Bestrahlung mit einem Energiestrahl, insbesondere bei Bestrahlung mit dem Energiestrahl aus einer zumindest im wesentlichen einheitlichen Raumrichtung, für eine Veränderung des Auflageortes des Widerlagers in wenigstens zwei unterschiedliche Raumrichtungen ausgebildet sind. Hierdurch kann beispielsweise während eines Einstellvorgangs zunächst über Bestrahlung eines ersten Formänderungsbereichs des Einstellmittels zunächst eine Grobeinstellung einer Position des Dichtmittels und/oder einer Vorspannung des Aktors und/oder einer Position eines Widerlagers für den Aktor erreicht werden. Dabei kann insbesondere vorgesehen werden, dass die Grobeinstellung über das angestrebte Ziel hinausgeht und anschließend im Rahmen einer Feineinstellung, die durch Einflussnahme auf wenigstens einen weiteren Formänderungsbereich vorgenommen wird, eine Änderung der Position des Dichtmittels entgegen der Richtung der vorausgegangenen Grobeinstellung und/oder eine Reduzierung der aufgebauten Vorspannung des Aktors und/oder eine Rückstellung der Position des Widerlagers für den Aktor um einen geringen Betrag vorgenommen wird, um eine möglichst präzise Einstellung des Aktors zu ermöglichen. Hierbei ist es vorteilhaft, wenn die Veränderung der Position des Widerlagers durch die Bestrahlung der unterschiedlichen Formänderungsbereiche des Einstellmittels in einander entgegengesetzte Richtungen stattfindet.

Vorzugsweise ist ein Formänderungsbereich als Krümmungsbereich ausgebildet und eine Krümmungsebene des Formänderungsbereichs schließt einen Winkel mit einer Bewegungsebene des Aktors, insbesondere mit einer Bewegungsebene eines Biegeelements ein, insbesondere ist die Krümmungsebene quer zur Bewegungsebene ausgerichtet. Eine Ausbildung des Formänderungsbereichs als Krümmungsbereich liegt beispielsweise dann vor, wenn der Formänderungsbereich zunächst eben ist und durch Einwirkung des Energiestrahls eine gekrümmte Form einnimmt. Ein Krümmungsbereich ist auch gegeben, wenn der Formänderungsbereich zunächst gekrümmt ist und durch Einwirkung des Energiestrahls zumindest nahezu eben wird. Ein typischer Krümmungsbereich liegt vor, wenn durch Einwirkung des Energiestrahls eine Verstärkung einer bereits bestehenden Krümmung erreicht wird. Die gewünschte Krümmung des Formänderungsbereichs wird durch das lokale Aufschmelzen der bestrahlten Oberfläche des Einstellmittels erreicht. Hierbei werden oberflächliche Spannungen im Material des Einstellmittels hervorgerufen, die die Krümmungsänderung bewirken. Die Krümmungsebene ist diejenige Ebene, in der eine Veränderung eines Krümmungsradius für den Krümmungsbereich bei Einwirkung eines Energiestrahls am stärksten auftritt. In der Krümmungsebene findet also die stärkste Querschnittsveränderung für das Einstellmittel während der Einwirkung des Energiestrahls statt, wobei hier keine Änderung einer Materialstärke angestrebt wird, sondern der aufbau von inneren Spannungen im Einstellmittel zur Bewirkung einer Gestaltänderung. Diese Krümmungsebene nimmt einen Winkel gegenüber der Bewegungsebene des Biegeelements ein, wobei der Winkel vorzugweise 90 Grad beträgt. Vorzugsweise schneiden sich die Krümmungsebene und die Bewegungsebene derart, dass eine Schnittlinie der beiden Ebenen auch das Einstellmittel schneidet.

Bevorzugt ist ein Formänderungsbereich als Krümmungsbereich ausgebildet und eine Krümmungsebene des Formänderungsbereichs ist parallel zu einer Bewegungsebene des Aktors ausgerichtet. Hierdurch wird eine kompakte Bauweise für das Fluidventil erleichtert.

Zweckmäßig ist es, wenn die Krümmungsebenen der Formänderungsbereiche einen Winkel zueinander einnehmen, insbesondere quer zueinander ausgerichtet sind. Hierdurch kann ein vorteilhafter Kompromiss zwischen einer kompakten Bauform und einer weitreichenden Einstellbarkeit für das Einstellmittel erreicht werden.

In weiterer Ausgestaltung der Erfindung ist das Einstellmittel am Ventilgehäuse abgestützt, insbesondere zwischen dem Aktor und einem Ventilgehäuseabschnitt angeordnet. Hierdurch wird ein vorteilhafter Kraftfluss zwischen dem Ventilgehäuse, dem Aktor und dem Einstellmittel gewährleistet. Bevorzugt ist der Aktor abseits des Einstellmittels an einem weiteren Ort am oder im Ventilgehäuse angebracht.

Vorteilhafte Ausführungsformen der Erfindung sind in der Zeichnung dargestellt. Hierbei zeigt:
- Figur 1: ein Fluidventil mit einer ersten Ausführungsform eines Einstellmittels,
- Figur 2: das Einstellmittel gemäß der Figur 1 in den drei Hauptansichten,
- Figur 3: eine zweite Ausführungsform eines Einstellmittels in den drei Hauptansichten,
- Figur 4: eine dritte Ausführungsform eines Einstellmittels in den drei Hauptansichten,
- Figur 5: eine vierte Ausführungsform eines Einstellmittels in den drei Hauptansichten, und
- Figur 6: eine fünfte Ausführungsform eines Einstellmittels in den drei Hauptansichten.

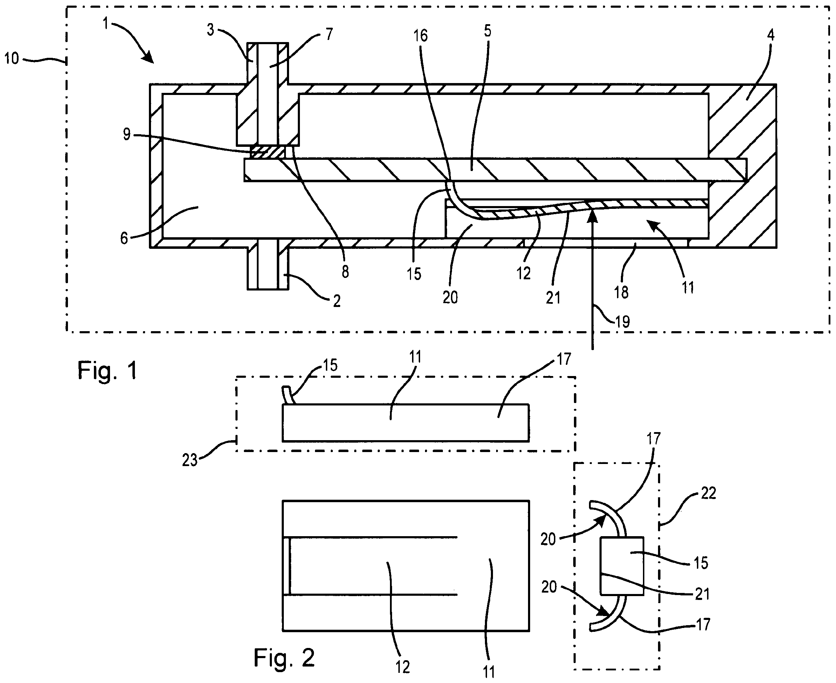

Ein in der Figur 1 dargestelltes Fluidventil 1 dient zur Beeinflussung einer Fluidströmung von einer nicht näher dargestellten, an einem Eingangsanschluss 2 anschließbaren Fluidquelle zu einem nicht dargestellten, an einem Ausgangsanschluss 3 anschließbaren Fluidverbraucher.

Das Fluidventil 1 umfasst hierzu ein Ventilgehäuse 4, in dem ein Aktor 5 aufgenommen ist, der exemplarisch als Piezobiegewandler ausgebildet ist und der somit durch Anlegen einer elektrischen Spannung zwischen einer in der Figur 1 dargestellten ersten Funktionsstellung und einer nicht dargestellten zweiten Funktionsstellung bewegbar ist. Das Ventilgehäuse 4 kann je nach Einsatzzweck des Fluidventils 1 abgedichtet ausgebildet sein, so dass ein vom Ventilgehäuse 4 umschlossener Ventilraum 6, in dem der Aktor 5 angeordnet ist, für Fluid lediglich über den Eingangsanschluss 2 und den Ausgangsanschluss 3 zugänglich ist. Alternativ kann vorgesehen sein, dass das Ventilgehäuse 4 nicht abgedichtet ausgebildet ist, sondern in ein Trägergehäuse einsetzbar ist, das zur Bereitstellung der notwendigen Abdichtwirkung ausgebildet ist. Das Fluidventil 1 gemäß der Figur 1 umfasst ein nicht abgedichtetes Ventilgehäuse 4.

Vorliegend ist im Ventilgehäuse 4 der Ausgangsanschluss 3 als Abschnitt eines Fluidkanals 7 ausgebildet, der das Ventilgehäuse 4 bereichsweise durchsetzt und der im Ventilgehäuse 4 an einem Ventilsitz 8 ausmündet. Der Ventilsitz 8 ist exemplarisch als ebene Kreisringfläche ausgebildet und kann mit Hilfe eines Dichtmittels 9, das mit dem Aktor 5 bewegungsgekoppelt ist, zeitweilig verschlossen werden, wodurch ein Fluidstrom durch längs des Fluidkanals 7 durch das Fluidventil 1 unterbunden wird. Das Dichtmittel 9 kann durch die Kopplung mit dem Aktor 5 in Abhängigkeit von der jeweils durch den Aktor 5 eingenommenen Funktionsstellung abdichtend auf den Ventilsitz 8 aufgelegt oder aufgepresst werden oder zeitweilig vom Ventilsitz 8 abgehoben werden, um einen Fluidstrom durch den Fluidkanal 7 zu ermöglichen.

Der als Piezobiegewandler ausgebildete Aktor 5 ist für eine Bewegung in einer Bewegungsebene 10 ausgebildet, die vorliegend mit der Darstellungsebene der Figur 1 übereinstimmt. Durch eine Krümmung des endseitig ortsfest am Ventilgehäuse 4 angebrachten Aktors 5, die vorzugsweise gemäß der Darstellung der Figur 1 entgegen dem Uhrzeigersinn in der Bewegungsebene erfolgt, wird das vorzugsweise stoffschlüssig am Aktor 5 festgelegte Dichtmittel 9 vom Ventilsitz abgehoben, um den Fluidkanal 7 freizugeben.

Exemplarisch ist der Aktor 5 derart ausgebildet, dass er bei Bereitstellung von elektrischen Energie aus der in Figur 1 dargestellten ersten Funktionsstellung in eine nicht dargestellte zweite Funktionsstellung bewegt wird. Bei Abschalten der elektrischen Energie soll gewährleistet werden, dass der Aktor 5 das Dichtmittel 9 wieder zuverlässig abdichtend am Ventilsitz 8 zur Anlage bringt. Hierzu ist beispielhaft ein Einstellmittel 11 vorgesehen, das eine Rückstellbewegung des Aktors 5 aus der zweiten Funktionsstellung in die erste Funktionsstellung in der Art eines Vorspannmittels unterstützt, das eine Vorspannkraft auf den Aktor 5 zum Erreichen der ersten Funktionsstellung bereitstellt.

Das in der Figur 1 geschnitten dargestellte und in der Figur 2 in den Hauptansichten gezeigte Einstellmittel 11 ist vorzugsweise aus einem Metallmaterial hergestellt und weist exemplarisch in einer Querschnittsebene einen U-förmigen Querschnitt auf, von dem eine zentral angeordnete Zunge 12 abragt. Die Zunge 12 weist ihrerseits exemplarisch einen viertelkreisartig ausgebildeten Endbereich 15 auf, dessen Stirnfläche 16 an einer Unterseite des exemplarisch als langgestrecktem Balken ausgeführten Aktors 5 anliegt. Wie aus der Figur 2 entnommen werden kann, ist die Zunge 12 aus dem an sich U-förmigen Einstellmittel 11 ausgeschnitten. Dabei sind die beiden U-Schenkel 17 des Einstellmittels 11 in entgegengesetzter Richtung zum Endbereich 15 gekrümmt ausgebildet. Ferner ist eine Krümmungsebene 22 der U-Schenkel 17 orthogonal, also quer, zu einer Krümmungsebene 23 des Endbereichs 15 ausgerichtet. In der Figur 1 ist die Krümmungsebene 23 des Endbereichs 15 identisch mit der Bewegungsebene 10 des Aktors 5, während die Krümmungsebene 22 der U-Schenkel 11 senkrecht hierzu ausgerichtet ist.

Um eine Einstellung des Einstellmittels 11 zu ermöglichen, ist im Ventilgehäuse 4 eine fensterartige Aussparung 18 vorgesehen, durch die ein schematisch angedeuteter Energiestrahl 19, der exemplarisch ein Laserstrahl oder ein Elektronenstrahl sein kann, von außen auf das Einstellmittel 11 auftreffen kann, um dieses durch lokales Aufschmelzen von Formänderungsbereichen in seiner Krümmung zu beeinflussen.

Bei einer nicht dargestellten Ausführungsform des Ventilgehäuses ist dieses vollständig oder zumindest bereichsweise aus einem Material hergestellt, das für den Energiestrahl zumindest im Wesentlichen transparent ist, so dass eine Einstellung einer Krümmung des Einstellmittels auch durch einen Wandbereich des Ventilgehäuses hindurch vorgenommen werden kann. Dies ist insbesondere dann vorteilhaft, wenn das Ventilgehäuse abgedichtet ausgeführt ist, da in diesem Fall auch nach Herstellung aller abdichtenden Verbindungen am Ventilgehäuse eine Einstellung des Aktors und des damit bewegungsgekoppelten Dichtmittels ermöglicht wird.

Das plastisch deformierbare Einstellmittel 11 ist vorzugsweise aus einem metallischen Werkstoff hergestellt und weist exemplarisch mehrere Formänderungsbereiche 20, 21 auf. Der erste Formänderungsbereich 20 wird von den beiden U-Schenkeln 17 gebildet, eine Einwirkung des Energiestrahls 19 in diesem Bereich führt zu einer Verstärkung der Krümmung des jeweiligen U-Schenkels 17, wodurch sich das Einstellmittel 11 stärker an den Aktor 5 annähert und somit der Endbereich 15 der Zunge 12 mit größerer Anpresskraft an dem Aktor 5 anliegt.

Bei einer Einwirkung des Energiestrahls 19 auf die Zunge 12 kommt es zu einer Verstärkung der vom Aktor 5 weggerichteten Krümmung der Zunge 12 und damit zu einer Reduzierung der vom Endbereich 15 der Zunge 12 auf den Aktor einwirkenden Kraft. Somit kann durch entsprechende Beaufschlagung eines oder mehrerer Formänderungsbereiche 20, 21 mit dem Energiestrahl die gewünschte Vorspannkraft eingestellt werden, die vom Einstellmittel 11 auf den Aktor 5 wirkt.

Bei einer nicht dargestellten Ausführungsform liegt der Endbereich der Zunge in der Neutralstellung des Aktors nicht am Aktor an, sondern bildet ein Widerlager für den Aktor, sobald dieser beim Übergang aus der ersten Funktionsstellung in die zweite Funktionsstellung mit dem Endbereich der Zunge in Berührung kommt. In diesem Fall kann die Position, in der der erste Berührkontakt zwischen Einstellmittel und Aktor stattfindet, mit Hilfe des auf die Formänderungsbereiche einwirkenden Energiestrahls eingestellt werden.

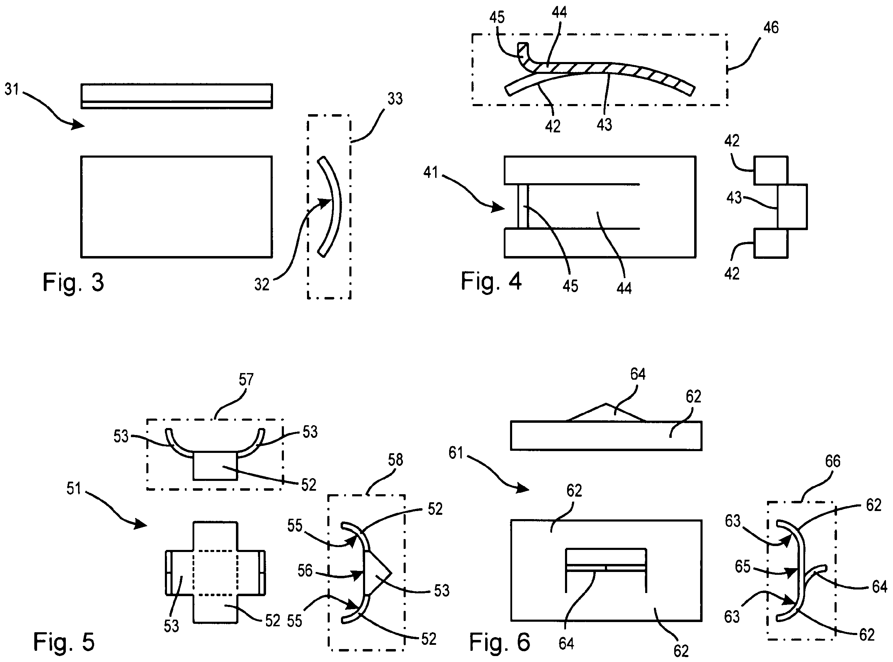

Die in der Figur 3 dargestellte Ausführungsform eines Einstellmittels 31, das als Ausschnitt aus einer Zylinderhülse ausgebildet ist, weist lediglich einen Formänderungsbereich 32 auf, so dass durch Einwirkung eines Energiestrahls lediglich eine Krümmungsänderung in einer einzigen Krümmungsebene 33 vollzogen werden kann. Vorzugsweise wird das Einstellmittel 31 derart gegenüber dem Aktor angeordnet, dass es mit seiner konvexen Oberfläche dem Aktor gegenüberliegt und je nach eingestellter Wölbung linienförmig am Aktor anliegt. Dabei kann die Krümmungsebene 33 des Einstellmittels 31 vorzugsweise parallel oder quer zur Bewegungsebene 10 ausgerichtet werden.

Bei dem in der Figur 4 dargestellten Einstellmittel 41 sind übereinstimmend mit dem Einstellmittel 11 zwei Formänderungsbereiche 42, 43 vorgesehen, wobei die beiden Formänderungsbereiche 42 bei Beaufschlagung mit einem Energiestrahl zu einer Annäherung eines Endbereichs 45 einer Zunge 44 an den nicht dargestellten Aktor oder zur Erhöhung einer vom Einstellmittel 41 auf den Aktor ausgeübten Vorspannkraft führen. Demgegenüber führt eine Beaufschlagung des Formänderungsbereichs 43 zu einer Krümmung der Zunge 44, wodurch sich der Endbereich 45 vom Aktor entfernt bzw. eine Vorspannkraft des Einstellmittels 41 auf den Aktor reduziert wird. Abweichend von dem Einstellmittel 11 führen bei dem Einstellmittel 41 sowohl die Beaufschlagung der Formänderungsbereiche 42 als auch die Beaufschlagung des Formänderungsbereichs 43 zu Krümmungsänderungen in einer gemeinsamen Krümmungsebene 46.

Das Einstellmittel 51 gemäß der Figur 5 weist eine doppelte U-Form mit entgegengesetzten U-Schenkeln auf. Dabei sind erste U-Schenkel 52 für eine Anlage am Ventilgehäuse vorgesehen und zweite U-Schenkel 53 sind jeweils in Endbereichen verjüngt ausgebildet, um ein vorteilhaftes Abwälzen des Aktors auf den Endbereich zu ermöglichen, sobald dieser in Anlage an der Unterseite des Aktors kommt. Die Formänderungsbereiche 55, 56 ermöglichen eine gezielte, gegebenenfalls auch asymmetrische Einstellung der Positionen der beiden Berührpunkte, mit denen die Endbereiche am Aktor zur Anlage kommen können. Hierdurch können gegebenenfalls auch unerwünschte Torsionsspannungen im Aktor zumindest teilweise kompensiert werden, um eine flächige Auflage und damit eine abdichtende Anlage des Dichtmittels auf dem Ventilsitz zu gewährleisten. Das Einstellmittel 61 weist zwei U-Schenkel 62 auf, die einen ersten Formänderungsbereich 63 bestimmen. Ferner ist am Einstellmittel 61 ein verjüngter Endbereich 64 ausgebildet, der einen zweiten Formänderungsbereich 65 bestimmt. Übereinstimmend mit dem Einstellmittel 41 sind beide Formänderungsbereiche 63, 65 in der gleichen Krümmungsebene 66 angeordnet, wobei die Ausrichtung des Einstellmittels 61 gegenüber dem Aktor vorzugsweise derart vorgenommen wird, dass die Krümmungsebene 66 quer zur Bewegungsebene verläuft.

## Patentansprüche

1. Fluidventil zur Beeinflussung einer Fluidströmung, mit einem Ventilgehäuse (4), in dem ein Aktor (5) aufgenommen ist, der zwischen einer ersten und einer zweiten Funktionsstellung bewegbar ist, mit einem Fluidkanal (7), der das Ventilgehäuse (4) bereichsweise durchsetzt und im Ventilgehäuse (4) an einem Ventilsitz (8) ausmündet, mit einem Dichtmittel (9), das am Aktor (5) festgelegt ist und das in Abhängigkeit von der Funktionsstellung des Aktors (5) für eine zeitweilige Abdichtung des Ventilsitzes (8) ausgebildet ist, wobei dem Aktor (5) ein plastisch deformierbares Einstellmittel (11; 31; 41; 51; 61) zugeordnet ist, das zur Einwirkung auf den Aktor (5) ausgebildet ist, um eine Einstellung einer Position des Dichtmittels (9) in wenigstens einer der Funktionsstellungen des Aktors (5) zu ermöglichen, wobei das Einstellmittel als positionsveränderliches Widerlager für den Aktor (5) ausgebildet ist, wobei das Einstellmittel (11; 31; 41; 51; 61) zur Veränderung eines Auflageortes des Widerlagers am Aktor (5) mittels eines Energiestrahls (19), insbesondere eines Laserstrahls, ausgebildet ist.

2. Fluidventil nach Anspruch 1, **dadurch gekennzeichnet, dass** der Aktor (5) als elektrisch ansteuerbares Biegeelement, insbesondere als Piezobiegeelement, für eine Biegebewegung in einer Bewegungsebene (10) ausgebildet ist.

3. Fluidventil nach einem der Ansprüche 1 oder 2, **dadurch gekennzeichnet, dass** am Einstellmittel (11; 31; 41; 51; 61) ein Formänderungsbereich (20, 21; 32; 42, 43; 55, 56; 63, 65) ausgebildet ist, der bei Bestrahlung mit einem Energiestrahl (19) für eine Veränderung des Auflageortes des Widerlagers am Aktor (5) ausgebildet ist.

4. Fluidventil nach Anspruch 1 oder 2, **dadurch gekennzeichnet, dass** am Einstellmittel (11; 31; 41; 51; 61) mehrere Formänderungsbereiche (20, 21; 32; 42, 43; 55, 56; 63, 65) ausgebildet sind, die bei Bestrahlung mit einem Energiestrahl (19), insbesondere bei Bestrahlung mit dem Energiestrahl aus einer zumindest im wesentlichen einheitlichen Raumrichtung, für eine Veränderung des Auflageortes des Widerlagers in wenigstens zwei unterschiedliche Raumrichtungen ausgebildet sind.

5. Fluidventil nach Anspruch 3 oder 4, **dadurch gekennzeichnet, dass** ein Formänderungsbereich (20, 21; 32; 42, 43; 55, 56; 63, 65) als Krümmungsbereich ausgebildet ist und eine Krümmungsebene (22; 33; 46; 66) des Formänderungsbereichs (20, 21; 32; 42, 43; 55, 56; 63, 65) einen Winkel mit einer Bewegungsebene (10) des Aktors (5), insbesondere mit einer Bewegungsebene (10) eines Biegeelements einschließt, insbesondere ist die Krümmungsebene (22; 33; 46; 66) quer zur Bewegungsebene(10) ausgerichtet.

6. Fluidventil nach Anspruch 3 oder 4, **dadurch gekennzeichnet, dass** ein Formänderungsbereich (20, 21; 32; 42, 43; 55, 56; 63, 65) als Krümmungsbereich ausgebildet ist und eine Krümmungsebene (22; 33 ;46; 66) des Formänderungsbereichs (20, 21; 32; 42, 43; 55, 56; 63, 65) parallel zu einer Bewegungsebene (10) des Aktors (5) ausgerichtet ist.

7. Fluidventil nach Anspruch 4, **dadurch gekennzeichnet, dass** die Krümmungsebenen der Formänderungsbereiche (20, 21; 32; 42, 43; 55, 56; 63, 65) einen Winkel zueinander einnehmen, insbesondere quer zueinander ausgerichtet sind.

8. Fluidventil nach einem der vorhergehenden Ansprüche, **dadurch gekennzeichnet, dass** das Einstellmittel (11; 31; 41; 51; 61) am Ventilgehäuse (4) abgestützt ist, insbesondere zwischen dem Aktor (4) und einem Ventilgehäuseabschnitt angeordnet ist.

## Claims

1. Fluid valve for influencing a fluid flow, comprising a valve housing (4), in which an actuator (5) movable between a first and a second functional position is accommodated, a fluid passage (7), which passes through a region of the valve housing (4) and terminates at a valve seat (8) in the valve housing (4), and a sealing means (9), which is located on the actuator (5) and designed for temporarily sealing the valve seat (8) depending on the functional position of the actuator (5), wherein the actuator (5) is assigned a plastically deformable adjusting means (11; 31; 41; 51; 61) designed to influence the actuator (5) in order to facilitate an adjustment of a position of the sealing means (9) in at least one of the functional positions of the actuator (5), wherein the adjusting means is designed as a position-variable abutment for the actuator (5), wherein the adjusting means (11; 31; 41; 51; 61) is designed to change a contact location of the abutment on the actuator (5) by means of an energy beam (19), in particular a laser beam.

2. Fluid valve according to claim 1, **characterised in that** the actuator (5) is designed as an electrically controllable bending element, in particular a piezoelectric bending element, for a bending movement in a movement plane (10).

3. Fluid valve according to claim 1 or 2, **characterised in that** a shape changing region (20, 21; 32; 42, 43; 55, 56; 63, 65) designed to change the contact location of the abutment on the actuator (5) if irradiated with an energy beam (19) is formed on the adjusting means (11; 31; 41; 51; 61).

4. Fluid valve according to claim 1 or 2, **characterised in that** several shape changing regions (20, 21; 32; 42, 43; 55, 56; 63, 65) designed to change the contact location of the abutment in at least two different spatial directions if irradiated with an energy beam (19), in particular if irradiated with the energy beam from an at least substantially uniform spatial direction, are formed on the adjusting means (11; 31; 41; 51; 61).

5. Fluid valve according to claim 3 or 4, **characterised in that** a shape changing region (20, 21; 32; 42, 43; 55, 56; 63, 65) is designed as a curvature region, and **in that** a curvature plane (22; 33; 46; 66) of the shape changing region (20, 21; 32; 42, 43; 55, 56; 63, 65) encloses an angle with a movement plane (10) of the actuator (5), in particular with a movement plane (10) of a bending element, the curvature plane (22; 33; 46; 66) being in particular oriented transversely to the movement plane (10).

6. Fluid valve according to claim 3 or 4, **characterised in that** a shape changing region (20, 21; 32; 42, 43; 55, 56; 63, 65) is designed as a curvature region, and **in that** a curvature plane (22; 33; 46; 66) of the shape changing region (20, 21; 32; 42, 43; 55, 56; 63, 65) is oriented parallel to a movement plane (10) of the actuator (5).

7. Fluid valve according to claim 4, **characterised in that** the curvature planes of the shape changing regions (20, 21; 32; 42, 43; 55, 56; 63, 65) enclose an angle with one another, being in particular oriented transversely to one another.

8. Fluid valve according to any of the preceding claims, **characterised in that** the adjusting means (11; 31; 41; 51; 61) is supported on the valve housing (4), in particular between the actuator (4) and a valve housing section.

## Revendications

1. Soupape de fluide servant à influencer un écoulement de fluide, avec un boîtier de soupape (4), dans lequel un actionneur (5) est logé, lequel peut être déplacé entre une première et une deuxième position fonctionnelle, avec un canal de fluide (7), qui traverse par endroits le boîtier de soupape (4) et qui débouche dans le boîtier de soupape (4) au niveau d'un siège de soupape (8), avec un moyen d'étanchéité (9), qui est fixé au niveau de l'actionneur (5) et qui est réalisé en vue d'une étanchéification temporaire du siège de soupape (8) en fonction de la position fonctionnelle de l'actionneur (5), dans laquelle un moyen de réglage (11 ; 31 ; 41 ; 51 ; 61) pouvant être déformé plastiquement est associé à l'actionneur (5), lequel est réalisé afin d'agir sur l'actionneur (5) afin de permettre un réglage d'une position du moyen d'étanchéité (9) dans au moins une des positions fonctionnelles de l'actionneur (5), dans laquelle le moyen de réglage est réalisé sous la forme d'une butée à position variable pour l'actionneur (5), dans laquelle le moyen de réglage (11 ; 31 ; 41 ; 51 ; 61) est réalisé afin de modifier un emplacement de pose de la butée au niveau de l'actionneur (5) au moyen d'un rayon d'énergie (19), en particulier d'un rayon laser.

2. Soupape de fluide selon la revendication 1, **caractérisée en ce que** l'actionneur (5) est réalisé sous la forme d'un élément de flexion pouvant être commandé électriquement, en particulier sous la forme d'un élément de flexion piézoélectrique, en vue d'un déplacement de flexion dans un plan de déplacement (10).

3. Soupape de fluide selon l'une quelconque des revendications 1 ou 2, **caractérisée en ce qu'**est réalisée, au niveau du moyen de réglage (11 ; 31 ; 41 ; 51 ; 61), une zone de changement de forme (20, 21 ; 32 ; 42, 43 ; 55, 56 ; 63, 65), qui est réalisée lors d'un rayonnement avec un rayon d'énergie (19) en vue d'une modification de l'emplacement de pose de la butée au niveau de l'actionneur (5).

4. Soupape de fluide selon la revendication 1 ou 2, **caractérisée en ce que** sont réalisées, au niveau du moyen de réglage (11 ; 31 ; 41 ; 51 ; 61), plusieurs zones de changement de forme (20, 21 ; 32 ; 42, 43 ; 55, 56 ; 63, 65), qui sont réalisées lors du rayonnement avec un rayon d'énergie (19), en particulier lors du rayonnement avec le rayon d'énergie depuis une direction spatiale au moins sensiblement homogène, en vue d'une modification de l'emplacement de pose de la butée dans au moins deux directions spatiales différentes.

5. Soupape de fluide selon la revendication 3 ou 4, **caractérisée en ce qu'**une zone de changement de forme (20, 21 ; 32 ; 42, 43 ; 55, 56 ; 63, 65) est réalisée sous la forme d'une zone de courbure, et un plan de courbure (22 ; 33 ; 46 ; 66) de la zone de changement de forme (20, 21 ; 32 ; 42, 43 ; 55, 56 ; 63, 65) forme un angle avec un plan de déplacement (10) de l'actionneur (5), en particulier avec un plan de déplacement (10) d'un élément de flexion, en particulier **en ce que** le plan de courbure (22 ; 33 ; 46 ; 66) est orienté de manière transversale par rapport au plan de déplacement (10).

6. Soupape de fluide selon la revendication 3 ou 4, **caractérisée en ce qu'**une zone de changement de forme (20, 21 ; 32 ; 42, 43 ; 55, 56 ; 63, 65) est réalisée sous la forme d'une zone de courbure, et un plan de courbure (22 ; 33 ; 46 ; 66) de la zone de changement de forme (20, 21 ; 32 ; 42, 43 ; 55, 56 ; 63, 65) est orienté de manière parallèle par rapport à un plan de déplacement (10) de l'actionneur (5).

7. Soupape de fluide selon la revendication 4, **caractérisée en ce que** les plans de courbure des zones de changement de forme (20, 21 ; 32 ; 42, 43 ; 55, 56 ; 63, 65) forment un angle les uns par rapport aux autres, en particulier sont orientés de manière transversale les uns par rapport aux autres.

8. Soupape de fluide selon l'une quelconque des revendications précédentes, **caractérisée en ce que** le moyen de réglage (11 ; 31 ; 41 ; 51 ; 61) prend appui au niveau du boîtier de soupape (4), en particulier est disposé entre l'actionneur (4) et un tronçon de boîtier de soupape.
